(19) Europäisches Patentamt

European Patent Office

Office européen des brevets

(11) **EP 1 001 049 A1**

(12) **EUROPEAN PATENT APPLICATION**

(43) Date of publication:
**17.05.2000 Bulletin 2000/20**

(51) Int. Cl.[7]: **C23C 16/44**, C23C 16/30, C30B 25/02

(21) Application number: **98309286.7**

(22) Date of filing: **13.11.1998**

(84) Designated Contracting States:
**AT BE CH CY DE DK ES FI FR GB GR IE IT LI LU MC NL PT SE**
Designated Extension States:
**AL LT LV MK RO SI**

(71) Applicant: **Epichem Limited**
**Wirral, Merseyside L61 1TZ (GB)**

(72) Inventors:
• **Ravetz, Megan S.**
**Newton, Chester, CH2 2DN (GB)**
• **Smith, Lesley M.**
**Heswall, Wirral, L60 0BG (GB)**

• **Leese, Barry A.**
**Alsager, Staffordshire, ST7 2HD (GB)**
• **Rushworth, Simon A.**
**Irby, Wirral, L61 3XR (GB)**
• **Kanjolia, Ravi**
**North Andover, MA 01845 (US)**

(74) Representative:
**Lyons, Andrew John et al**
**ROYSTONS,**
**Tower Building,**
**Water Street**
**Liverpool L3 1BA, Merseyside (GB)**

(54) **Process for purification of organometallic compounds**

(57) A process for the purification of organometallic compounds, particularly trimethyl indium, for use as precursors in the production of metal layers by chemical vapour deposition techniques. A low volatility amine, such as N-N-dimethyldodecylamine, is introduced into a vessel containing the vapourised precursor to remove any oxygen contaminants. The process enables the production of metal layers from the precursor having reduced oxygen contamination.

EP 1 001 049 A1

## Description

The present invention relates to a process for the purification of organometallic compounds for use in chemical vapour deposition techniques and in particular, to the purification of trimethyl indium.

Organometallic compounds, such as trimethyl indium are used as precursors to deposit thin layers of a metal, or mixture of metals, onto a solid substrate by chemical vapour deposition techniques, such as Metal Organic Vapour Phase Epitaxy (MOVPE). The metal films are important for the production of compound semi-conductors for use in the electronic and opto-electronic industry.

Recently, new alloy compositions containing high levels of aluminium, such as AlGaInP, have been developed which are particularly useful for the production of high brightness LED's which consume less power than conventional LED's and may be produced in a variety of colours and for indium based solar cells which are used in satellites. However, the performance of such layers is particularly sensitive to trace levels of oxygen containing species which may be introduced into the layers during the deposition process. Typical impurities which may be present in the precursor include diethyl ether, trimethyl indium - diethyl ether adduct, dimethyl indium monomethoxide, methyl indium dimethoxide and trimethoxyindium.

The oxygen containing species may be introduced into the precursors from a number of sources, such as from the raw materials used to produce the precursor and/or from solvents, eg. ether, used in the process for manufacturing the precursor. Oxygen contamination may also be introduced from air entering the source container, or bubbler, which then reacts with the organometallic compound to produce alkoxides. The carrier gas which assists in transportation of the vaporised precursor to the substrate may also contain oxygen species which may react with the organometallic compound to produce alkoxides.

The oxygen containing species present in the organometallic precursor is transported with the compound by the carrier gas into the reactor where the compounds are broken down and any oxygen is preferentially incorporated into the deposited layers. The performance of any semi-conductor device fabricated from such a contaminated layer is severely degraded.

The present invention aims to overcome the problem of oxygen contamination of organometallic precursors thereby enabling the production of improved metal films, particularly for use in high brightness LED's and solar cells.

Accordingly, the present invention provides a process of purifying an organometallic precursor for use in producing a metal layer by a chemical vapour deposition technique comprising the steps of providing the precursor in a vessel, introducing an amine into the vessel, vaporising the precursor and transporting the vaporised precursor from the vessel whereby the amine reduces oxygen contamination of the vaporised precursor.

The process preferably comprises the further step of depositing the metal of the precursor on a substrate.

Generally, the precursor is vaporised in a bubbler and transported to the substrate in a carrier gas, such as nitrogen. Preferably, an amine solvent is provided in the them from the vapour and thereby reduce oxygen contamination of the precursor. The reduction in the vapour pressure of the oxygen containing species prevents transportation of the species in the carrier gas containing the precursor and accordingly, prevents its incorporation into the deposited layer.

Preferably, the amine is of low volatility to prevent its transportation in the carrier gas from the bubbler. It is also preferable to provide an amine having a lower density than the non-vaporised precursor. The amine is preferably provided above the bottom of the pipe which transports the carrier gas and vaporised precursor from the vessel to ensure agitation and contact of all of the precursor with the amine.

The preferred amines for use in the process of the invention are tertiary amines, especially N-N-dimethyldodecylamine.

The process of the present invention is particularly suitable for use in the production of indium layers using the precursor, trimethylindium. However, other compounds of indium may be used in a similar manner, for example $R_3In$ where $R=C_1-C_4$. The process may also be used for deposition of other metal layers and mixed metal layers, particularly Group III and V metal layers, such as AlInAs and AlGaInP.

The solution of the organometallic precursor in an amine may be used as a getter to remove oxygen impurities by passing vapours of the precursor containing trace oxygen contaminants from a prior source bubbler through the amine solution.

The process of the present invention provides metal layers formed by chemical vapour deposition techniques having reduced levels of oxygen contamination. These high quality layers are particularly suitable for the fabrication of devices for use in and high intensity LEDS. The layers may be formed by one of a number of chemical vapour deposition techniques, particularly metal organic vapour phase epitaxy (MOVPE).

The present invention will now be further illustrated by means of the following examples.

Example 1

A 50g sample of trimethyl indium, previously analysed by FTNMR for ether impurity, was placed in a glass 'bubbler'. 10g of N-N dimethyldodecylamine was added to the bubbler and the resultant mixture was gently agitated and allowed to stand for 12 hours. High purity nitrogen gas was then passed through the dip leg at the rate of 1 litre per minute. The resultant entrained trimethyl indium was collected in a glass receiver cooled to -20°C. The collected trimethyl indium was then analysed using FTNMR and the results compared. It was found that the analysis of the first sample showed a level of diethyl ether of 56ppm. In the 2nd sample no ether was detected at the sensitivity of the instrument which had been shown to be 7ppm.

Example 2

A 200g sample of trimethyl indium was analysed by FTNMR for oxygen containing species and then separated into two. The first 100g was placed into a standard fully cleaned s/s bubbler which contained 17g of N,N-dimethyldodecyl amine. The second 100g was filled into a similar standard fully cleaned reverse flow bubbler. The two samples were then placed onto a CVT MOCVD reactor and used independently as In source material to grow AlInAs epitaxial layers. All other precursors and deposition conditions were kept constant. The layers grown using material from the two bubblers were then analysed for background carrier concentration and subsequently by SIMS (Secondary Ion Mass Spectrometry) for oxygen incorporation in the layers.

The initial analysis by FTNMR of the solid trimethyl indium showed levels of 40ppm ether.

| Analysis of Oxygen | Carrier Concentration | SIMS |
|---|---|---|
| Sample 1 | $(cm^{-3})$ | $(cm^{-3})$ |
|  | 7 x e15 | < 1 x 1017 (detection limit) |
| Sample 2 | 4 x e16 | 4 x 1017 |

The results clearly illustrate that the incorporation of an amine into the bubbler in which the trimethylindium is vaporised reduces the levels of oxygen containing species present in the vapourised precursor resulting in the deposition of a purer metal layer from the precursor. This occurs by the amine preferentially interacting with the oxygen containing species to reduce their vapour pressure and thereby prevent their transportation to the reactor by the carrier gas.

**Claims**

1.  A process of purifying an organometallic precursor for use in producing a metal layer by a chemical vapour deposition technique comprising the steps of providing the precursor in a vessel, introducing an amine into the vessel, vaporising the precursor and transporting the vaporised precursor from the vessel whereby the amine reduces oxygen contamination of the vaporised precursor.

2.  A process as claimed in claim 1, further comprising the step of depositing the metal of the precursor on a substrate.

3.  A process as claimed in claim 1 or claim 2, wherein the amine has a low volatility.

4.  A process as claimed in claim 1, 2 or 3, wherein the amine has a lower density than the non-vaporised precursor.

5.  A process as claimed in any one of claims 1 to 4, wherein the amine is a tertiary amine.

6.  A process as claimed in claim 5, wherein the amine is N-N-dimethyldodecylamine.

7.  A process as claimed in any one of claims 2 to 6, wherein the vaporised precursor is transported to the substrate in a carrier gas.

8.  A process as claimed in claim 7, wherein the amine is provided in solution in the vessel to preferentially react with oxygen containing species to remove them from the vapour.

9. A process as claimed in claim 8, wherein the amine is provided above the bottom of a pipe which transports the carrier gas and vaporised precursor from the vessel to the substrate.

10. A process as claimed in any one of the preceding claims, wherein the precursor is an organometallic compound of indium.

11. A process as claimed in claim 10, wherein the precursor is $R_3In$ where R is $C_1$ to $C_4$.

12. A process as claimed in claim 11, wherein the precursor is trimethyl indium.

13. A process as claimed in any one of the preceding claims for the production of Group III and Group V metal layers.

14. A process as claimed in any one of the preceding claims, wherein the chemical vapour deposition technique is metal organic vapour phase epitaxy.

15. A process as claimed in any one of the preceding claims for use as a getter to remove oxygen impurities from a precursor containing oxygen contamination by passing the vaporised precursor from a prior source vessel through the amine solution.

16. A high intensity light emitting diode produced from a metal layer deposited on a substrate by the process of any one of claims 1 to 15.

17. A solar cell produced from a metal layer deposited on a substrate by the process of any one of claims 1 to 15.

European Patent
Office

**EUROPEAN SEARCH REPORT**

Application Number

EP 98 30 9286

## DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | WO 93 03196 A (SHELL INT RESEARCH) 18 February 1993 * claims 1-6,9-13,18,19; example 2 * | 1-14 | C23C16/44 C23C16/30 C30B25/02 |
| X | FOSTER D F ET AL: "PURIFICATION OF GROUP III METAL ALKYLS USING NITROGEN DONOR LIGANDS" CHEMTRONICS., vol. 3, March 1988, pages 38-43, XP002099692 GUILDFORD GB *Pages 40-41, "Purification of group III metal alkyls* | 1,3,5, 10-12 | |
| X | DATABASE INSPEC INSTITUTE OF ELECTRICAL ENGINEERS, STEVENAGE, GB Inspec No. 5795178, DEPRETER B ET AL: "InP microcavity LED emitting at 1.55 mu m" XP002099693 * abstract * & CONFERENCE PROCEEDINGS. LEOS '97, 10TH ANNUAL MEETING. IEEE LASERS AND ELECTRO-OPTICS SOCIETY 1997 ANNUAL MEETING (CAT. NO.97CH36057), CONFERENCE PROCEEDINGS. LEOS '97. 10TH ANNUAL MEETING IEEE LASERS AND ELECTRO-OPTICS SOCIETY 1997 ANNUAL MEETING, S, pages 241-242 vol.1, ISBN 0-7803-3895-2, 1996, New York, NY, USA, IEEE, USA | 16 | |
| X | US 5 322 573 A (JAIN RAJ K ET AL) 21 June 1994 * column 6, line 44 - line 68; claims 1,5 * | 17 | |

TECHNICAL FIELDS
SEARCHED (Int.Cl.6)

C23C
C30B

-/--

The present search report has been drawn up for all claims

| Place of search | Date of completion of the search | Examiner |
|---|---|---|
| THE HAGUE | 14 April 1999 | Patterson, A |

EPO FORM 1503 03.82 (P04C01)

## EUROPEAN SEARCH REPORT

**Application Number**

EP 98 30 9286

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| A | EP 0 523 525 A (JAPAN PIONICS) 20 January 1993 * column 5, line 32 - line 41 * | 15 | |
| A | FREER R W ET AL: "CHEMICAL BEAM EPITAXIAL GROWTH OF HIGH OPTICAL QUALITY ALGAAS THE INFLUENCE OF PRECURSOR PURITY ON MATERIAL PROPERTIES.GAAS" JOURNAL OF CRYSTAL GROWTH, vol. 150, no. 1/04, PART 01, 1 May 1995, pages 539-545, XP000515118 * the whole document * | 1-17 | |
| | | | TECHNICAL FIELDS SEARCHED (Int.Cl.6) |

The present search report has been drawn up for all claims

| Place of search | Date of completion of the search | Examiner |
|---|---|---|
| THE HAGUE | 14 April 1999 | Patterson, A |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 98 30 9286

This annex lists the patent family members relating to the patent documents cited in the above-mentioned European search report.
The members are as contained in the European Patent Office EDP file on
The European Patent Office is in no way liable for these particulars which are merely given for the purpose of information.

14-04-1999

| Patent document cited in search report | | Publication date | Patent family member(s) | | Publication date |
|---|---|---|---|---|---|
| WO 9303196 | A | 18-02-1993 | AU | 2387192 A | 02-03-1993 |
| | | | JP | 6509389 T | 20-10-1994 |
| | | | US | 5232869 A | 03-08-1993 |
| US 5322573 | A | 21-06-1994 | NONE | | |
| EP 0523525 | A | 20-01-1993 | DE | 69202014 D | 18-05-1995 |
| | | | DE | 69202014 T | 31-08-1995 |
| | | | JP | 5202067 A | 10-08-1993 |
| | | | US | 5470555 A | 28-11-1995 |

EPO FORM P0459

For more details about this annex : see Official Journal of the European Patent Office, No. 12/82